# EUROPEAN PATENT APPLICATION

(11) **EP 2 330 874 A1**
(43) Date of publication of application: **08.06.2011**
(21) Application number: 09009206.5
(22) Date of filing: 15.07.2009
(51) Int. Cl.: H05K 1/09, C09D 11/00, H01G 9/20

(54) **Method for generation of ionic conducting surface structures and use**

(71) Applicant: Stichting Dutch Polymer Institute, 5612 AB Eindhoven (NL)
(72) Inventor: The designation of the inventor has not yet been filed
(74) Representative: Ackermann, Joachim

(57) **Abstract**

Disclosed is a method for generating conductive surface patterns on a substrate by printing a substrate with an ink comprising a polymerizable monomer and an ionic liquid and/or comprising a ionic liquid with at least one polymerizable group in the molecule and by causing the polymerizable monomer and/or the polymerizable group to form a polymer.
The process is easy to implement, needs only low energy, is very fast and can be used to generate ionic conductive patterns at low cost.

## Description

### Disclosure

### Method for generation of electrically conducting surface structures and use

This invention relates to the manufacture of electrically conducting surface patterns by a simple and efficient method, and to the use of this method for creation of electrically conductive surface patterns on a substrate.

Drop-on-demand inkjet printing of metal nanoparticles has gained considerable interest in recent years (J. B. Szczech, C. M. Megaridis, D. R. Gamota and J. Zhang, IEEE Trans. Electron. Packag. Manuf., 2002, 25, 26-33, and D. Huang, F. Liao, S. Molesa, D. Redinger and V. Subramanian, J. Electrochem. Soc., 2003, 150, G412-G417). This technique is used especially for printing conductive lines on foils and films.

Typically, the metal nanoparticles are deposited onto the surface as a suspension of surface-protected nanoparticles, which dries to leave a non-conductive or weakly conductive pattern of nanoparticles behind. In order to achieve good conductivity, this process is typically followed by a sintering process, whereby the nanoparticles are treated to remove the organic material between the nanoparticles, and to melt the particles together, forming a continuous path for electron transport. This sintering or annealing process is typically performed most commonly by heating the entire substrate to 150 - 250°C in an oven, by microwave irradiation or by laser sintering.

Currently, conductive inks contain micro- and nanospheres of conductive metal, for example silver, copper, nickel, platinum, palladium or gold. The sintering must be performed at elevated temperatures before the patterns are useful for most electronics applications. It is for this reason that inkjet printing of conductive inks are generally applied onto substrates that are less temperature-sensitive, such as glass, polyimides, or poly(tetraflurorethylene).

While heat sintering is a generally robust, well-developed technique, it is limited in its application to substrate materials that are able to withstand the high temperatures involved. Microwave sintering is a more recent development, but many materials and devices are incompatible with exposure to microwaves.

Laser sintering enables that the nanoparticle pattern may be selectively sintered, while leaving the surrounding surfaces unperturbed. Since the sintering process is guided by the laser itself, the curing process can be controlled to overlap the deposition pattern precisely. Coupling inkjet printing with laser sintering would allow for the flexibility of drop-on-demand rapid prototyping, as well as the superior spatial resoluton of constrained laser sintering (M. Dietzel, N. R. Bieri and D. Poulikakos, Int. J. Heat Fluid Flow, 2008, 29, 250-262, and S. H. Ko, J. Chung, H. Pan, C. P. Grigoropoulos and D. Poulikakos, Sens. Actuators, A, 2007, A134, 161-168, and S. H. Ko, H. Pan, C. P. Grigoropoulos, C. K. Luscombe, J. M. J. Frechet and D. Poulikakos, Nanotechnology, 2007, 18, 345202/345201-345202/345208). However, the use of laser sintering requires the allocation of additional capital-intensive instrumentation, which may not be practical to all workflows.

Alternatively, electrically conductive patterns may be prepared using poorly conductive or semiconductive organic or semimetallic materials, such as PEDOT, polycrystalline silicon, graphite paste, or amorphous carbon paste, although their conductivity is far lower than bulk transition metals, such as silver, gold, or copper, limiting many of their applications. In all such cases, the resulting materials tend to be brittle and yield darkened or discolored patterns on the surface where they are deposited. While in many cases this is acceptable, for printable electronics on finished surfaces, such solutions are suboptimal.

One other approach has been to silk-screen print a silver particle paste, and then to sinter the particles afterwards using laser sintering (Y. C. Lin and J. H. Jean, J. Am. Ceram. Soc., 2004, 87, 187-191). This combined approach of silkscreening followed by sintering allows for high-resolution conductive features to be printed, but is limited in the sense that a silk screen must be prepared for each circuit pattern, and is therefore not a flexible means of prototyping. Furthermore, the resolution achieved will be limited by how well the pattern is transferred from one system to the next.

Print electronic features using continuous aerosol spraying, including the printing of have also been reported recently (J. H. Cho, J. Lee, Y. Xia, B. Kim, Y. Y. He, M. J. Renn, T. P. Lodge and C. D. Frisbie, Nat. Mater., 2008, 7, 900-906). In this approach, a solution is atomized into droplets, which are then passed through a collimeter towards a target for deposition. While this technique is capable of microprinting conductive lines, the droplets formed are not on-demand, and vary in size (M. J. Renn, Optomec Design Company, US, 7270844, 2007). Furthermore, to be materially efficient, the system requires contant recycling of the unused ink during the process, limiting the process to inks that are stable under such conditions.

Powder bed printing coupled with laser sintering is also known (H. Exner, L. Hartwig, A. Streek, M. Horn, S. Klötzer, R. Ebert and P. Regenfuß, in 5. Jena Lasertagung, eds. J. Bliedtner and H. Mueller, DVS, Jena, Germany, 2006, pp. 153-163). Using this technique, a powder layer is deposited on a surface and then is sintered in place following a particular pattern. While this method allows for good feature resolution and is currently used as a popular method of rapid prototyping of metal parts, it requires large amounts of the powder, and is not directly applicable to liquid-based inks.

An additional problem related to the use of printed metallic particles for the manufacture of disposable electronics is the issue of heavy metals, and the contamination of the waste stream of a given product market. Most heavy metals are poorly tolerated by biological systems in elevated concentrations, and their release into the environment is best avoided, if possible. Current issues with "e-waste" related mostly to durable goods such as computers has already demonstrated considerable environmental hazards worldwide, and so the generation of disposable electronics without greater forethought poses its own risks, since such materials will inadvertently find their way into local landfills and incinerators.

Ionic liquids have appeared in recent years as novel compounds in materials research, and are already used in several industrial processes. One of the main characteristics of ionic liquids is the fact that their properties, such as viscosity, solubility, electrical conductivity, melting point, and biodegradability/biocompatibility can be tuned by varying the different involved anions and/or cations. In addition, some other intrinsic properties related to the stability and "green" characteristics of ionic liquids, such as negligible vapour pressure, negligible flammability and liquid state in a broad range of temperatures, makes them attractive materials for applied research. Nowadays, more than 300 ionic liquids are commercially available covering a wide range of physical and chemical properties, while more than 10⁶ simple ionic liquids have been theorized, and by extension, over 10¹⁸ theoretical ternary ionic liquids may be possible, making this a large and rich material space for investigation (E. F. Borra, O. Seddiki, R. Angel, D. Eisenstein, P. Hickson, K. R. Seddon and S. P. Worden, Nature, 2007, 447, 979-981). While such materials are conductive, they are liquid, and by themselves, lack the mechanical integrity to work effectively as printed conductive lines.

Known processes using printing techniques for the generation of electrically conductive patterns mostly use sintering or annealing steps for the generation of the electrically conductive pattern, or they use materials with only limited electrical conductivity. In view of the above, a process would be desirable which produces thin and printable electronic leads without a sintering step, which leads to stable patterns of material with good conductivity and viscoelasticity, and which is transparent or color-neutral. Materials with this combination of properties would have a wide array of applications, for example in the manufacture of flexible conductive leads for flexible and transparent displays, as well as related value-added electronics. One of the principle challenges concerns the deposition of highly conductive material in the form of patterns, in a non-destructive way, onto flexible polymer substrates. Elastic and preferably transparent conductive materials deposited by printing techniques without the need for thermal sintering have a wide range of applications.

It has been found that the efficiency of the preparation of electrically conducting surface patterns on a substrate can be improved with the judicious selection of an appropriate ink. Generally, when using this ink, a sintering or annealing step of the printed pattern can be avoided.

It is an objective of the present invention to provide an improved, fast, simple and cost-efficient technique that allows formation of electrically conductive surface patterns by a direct printing technique without the need for a subsequent sintering or annealing step.

The present invention relates to a process for generating electrically conducting surface patterns on a substrate surface comprising the steps:
i) drop-on-demand printing upon the surface of a substrate a predetermined pattern of a material containing a polymerizable monomer and an ionic liquid and/or an ionic liquid with at least one polymerizable group in the molecule, or alternatively, drop-on-demand printing upon the surface of a substrate a predetermined pattern of a material containg a polymerizable monomer followed by drop-on-demand printing of a predetermined pattern of a fluid containing an ionic liquid, or alternatively, drop-on-demand printing of a predetermined pattern of a material containing an ionic liquid, followed by deposition of a predetermined pattern of a material containing a polymerizable monomer, by printing said compositions onto a surface, and,
ii) after deposition of the monomer causing said polymerizable monomer and/or said polymerizable group to polymerize, forming a polymer thereby forming a polymerized, electrically conductive pattern on said surface.

The process of this invention uses an ink containing a polymerizable monomer and an ionic liquid. Alternatively, or in combination therewith, a polymerizable ionic liquid can be used. Alternatively, different inks containing a polymerizable monomer or a mixture thereof or containing an ionic liquid or a mixture thereof can be printed to the surface in either order to result in a combination of polymerizable monomer and of ionic liquid on the substrate surface or to result in a combination of polymer and of ionic liquid on the substrate surface.

Upon polymerization of the monomer and/or of the polymerizable ionic liquid, an electrically conductive polymer/ionic liquid composition is formed in a very efficient manner in the imprinted structures, and an electrically conductive pattern can be developed without any sintering or annealing step.

A large variety of substrates can be chosen for the method of this invention. Nonlimiting examples are polymers (thermoplastic and duroplastic polymers including elastomers); inorganic materials, such as glass or ceramic materials; semi-conducting substrates, such as silicon or gallium-arsenide, fibrous substrates containing natural and/or man-made fibers, such as paper, textile sheets including fabrics and non-wovens; sheet materials made from polymers and/or from natural materials, such as leather, wood or thermoplastic polymers; bulk materials made from polymers and/or from natural materials; or composites containing said sheet or bulk materials.

Suitable substrates can possess a large variety of properties. For example, they can be transparent or non-transparent, or they can be crystalline or non-crystalline or they can contain adjuvants, such as pigments, antistatic agents, fillers, reinforcing materials, lubricants, processing aids and heat and/or light stabilizers.

Preferred substrates are thermoplastic polymers, such as polyesters, for example polyethylene terephthalate or polybutylene terephthalate, or polyamides, for example Nylon-type polyamides, or polyimides, polyether-imides, polycarbonates, polyolefins, for example polyethylene or polypropylene, or polyetherketones, polysiloxanes and polyarylene sulphides, for example polyphenylene sulphide.

Very preferred substrate materials are polymers with a glass transition- or melting temperature below 180°C, such as polyesters, polyamides and polyolefins.

With regards to the material ("ink") forming the surface pattern, in general, each combination of a polymerizable monomer and an ionic liquid can be used, which can be printed to the substrate surface as a single ink comprising both ingredients or which can be printed to the substrate surface as a sequence of inks comprising polymerizable monomer and ionic liquid separately, provided that the ionic liquid may swell or adsorb to the polymer, such that the polymeric phase provides a continuous, ionic path through which a charge may be conducted. In this composition also mixtures of polymerizable monomers and/or mixtures of ionic liquids can be applied.

Different inks and sequences of steps a) and b) can be used in performing the process of this invention.

In one embodiment, an ink comprised of a polymerizable monomer and an ionic liquid is printed in the form of a pattern to the substrate surface, followed by polymerization of the monomer to form the electrically conductive pattern on the substrate surface.

In another embodiment, an ink which is comprised at least in part by a polymerizable monomer, is printed in the form of a pattern to the substrate surface, which is followed by the printing of a second ink containing an ionic liquid. The printing patterns of these two inks are concomitant to each other on the substrate surface. This is followed by polymerization of the monomer to form the electrically conductive pattern on the substrate surface.

In still another embodiment, an ink which is comprised at least in part by an ionic liquid, is printed in the form of a pattern to the substrate surface, which is followed by printing of a second ink containing polymerizable monomer. The printing patterns of these two inks are concomitant to each other on the substrate surface. This is followed by polymerization of the monomer to form the electrically conductive pattern on the substrate surface.

In still another embodiment, an ink which is comprised at least in part by a polymerizable monomer, is printed in the form of a pattern to the substrate surface, followed by polymerization of the monomer to form a crosslinked polymeric network. This is then followed by printing of a second ink, which is printed concomitant to the original pattern on the substrate surface, and is absorbed by the polymeric network yielding an ionic, polymeric electrically conductive pattern on the substrate surface. In still another embodiment, an ink comprised of a polymerizable monomer and an ionic liquid with polymerizable groups is printed in the form of a pattern to the substrate surface, followed by polymerization of the monomer to form the electrically conductive pattern on the substrate surface.

In addition to either the polymerizable ionic liquid or the ionic liquid and the polymerisable monomer, the ink can contain additional ingredients which are generally used for inks. For example, a co-solvent can be used in order to adjust the rheological properties and improve printability. Furthermore, additional non-liquid electrolytes, adhesion promoters, antifogging agents, antihydrolysis agents, antioxidants, antislip agents, antistatic agents, catalysts, cling agents, comonomers, compatibilizers, copolymers, crosslinkers, doping agents, dyes, fillers, flame retardants, leveling agent, light stabilizers, matting agent/gloss agent, nucleating agent, pigments, plasticizers, polymerization initiators, stabilizers, surfactants, thoxotropic agent, viscosity modifiers, wetting agents, and other performance modifiers can be used. The amount of such additional ingredients is in general below 80 % by weight, referring to the total amount of the ink.

The term "ionic liquid" as used in this specification shall mean a composition of matter being liquid at temperatures below 100°C, and consisting essentially of cations and anions to form an electroneutral composition of matter. In general, at least 95 % by weight, preferably at least 99 % by weight of an ionic liquid consists of cations and anions the remainder may consist of electically neutral species. An ionic liquid for use in the inks of this invention in general is a composition of matter having a melting temperature below 100 °C. Ionic liquids are salts or their mixtures consisting of at least one organic component. Ionic liquids can be miscible or immiscible with water, and reactive or non-reactive with water, air or other chemical species depending on their structure. The ionic liquid may polymerizable, yielding macromolecules with an ionic nature. The selection of a proper ionic liquid will depend on the desired physical and chemical properties of the prepared ink. Variation in cations and anions can produce a very wide range of ionic liquids, allowing for the fine-tuning of their physical and chemical properties for specific applications. The control on characteristics, such as hydrophilicity, can be obtained by changing the anion and a fine control on their properties can be obtained by selecting a proper alkyl group on the cation. The constituents of ionic liquids are constrained by high columbic forces and therefore exert negligible vapor pressure above the liquid surface. Ionic liquids show also negligible flammability under certain conditions (M. Deetlefs and K. R. Seddon, Chim. Oggi, 2006, 24, 16-17, 20-23, and M. Deetlefs, K. R. Seddon and M. Shara, Phys. Chem. Chem. Phys., 2006, 8, 642-649).

A wide variety of ionic liquids suitable for use in the inks of the present invention have been described. Examples of ionic liquids suitable for the inks of the present invention are known in the open literature (V. R. Koch, C. Nanjundiah and R. T. Carlin, (Covalent Associates, Inc., USA). WO, 9702252, 1997, and H. Olivier and A. Hirschauer, (Institut Francais du Petrole, Fr.). FR, 2757850, 1998, T. Welton, Coord. Chem. Rev., 2004, 248, 2459-2477).

The term ionic liquid as used in this specification can also include a class of less expensive ionic liquids that may be used as co-solvents to lower the overall cost of the inks, therefore mixtures of ionic liquids are contemplated and within the scope of the present invention. For example, N,N'-dialkylimidazolium bis(trifluoromethylsulfonyl)imide salts are expensive, but they can be mixed with tetraalkylammonium-based salts to obtain less expensive binary or tertiary ionic liquids. The mixtures are characterized to establish how this affects the physical and chemical properties of the ionic liquid mixtures.

Preferred inks contain an ionic liquid consisting to at least 95 % by weight of ions and being liquid at temperatures between -100 and +100°C.

Cations of ionic liquids are typically large, bulky, and asymmetric, and show a direct influence on the melting point of the ionic liquid. Common examples of cations include organoammonium, organophosphonium and organosulfonium ions, wherein the organo-group is a heterocyclic group, with at least one quaternary nitrogen or cationic phosphorus, or with at least one cationic tertiary sulfur atom. Examples of heterocyclic organo groups are pyridinium, imidazolium or pyrrolidinium groups with one or more substituents in the heteroring, or wherein the organo-group is an aliphatic group with at least one quaternary nitrogen or phosphorus or with at least one tertiary sulfur atom. Examples of heterocyclic organo groups are pyridinium, imidazolium or pyrrolidinium groups with one or more substituents in the hetero ring. Examples of aliphatic groups are saturated or ethylenically unsaturated straight-chain, ringed, or branched alkyl groups with one to twenty carbon atoms. Specific examples of organo ammonium, organophosphonium and organosulfonium ions are N-alkylpyridinium, N-alkyl-vinylpyridinium, tetraalkylammonium, tetraalkylphosphonium, trialkyl-sulfonium, N,N'-dialkylimidazolium, N-alkyl(aralkyl)-N'-alkylimidazolium, N-alkyl-N'-vinylimidazolium, N-alkyl-N'-allylimidazolium, N,N-dialkylbenzimidazolium, N,N-dialkylpyrrolidinium and other aliphatic quaternary ammonium-based compounds (*e.g*. the AMMOENG™ series from Solvent-Innovation GmbH.) Other heterocylcles containing at least one quaternary nitrogen or phosphorus or at least one tertiary sulfur are also suitable. Examples of heterocycles that contain a quaternary nitrogen include pyridazinium, pyrimidinium, oxazolium and triazolium ions.

Particularly, preferred cations are N-alkylpyridinium, tetraalkylammonium, tetraalkylphosphonium, trialkylsulfonium, and N,N' dialkylimidazolium, because of their low cost, ease of preparation, ready availability, and stability.

By varying the number of carbons and branching on the alkyl chains of these cations, the ion mobility and melting temperature of the ionic liquid and therefore the melting temperature of the corresponding ink and other physical properties, such as viscosity, can be easily be adjusted to a desirable value (P. Bonhote, A.-P. Dias, N. Papageorgiou, K. Kalyanasundaram and M. Graetzel, Inorg. Chem., 1996, 35, 1168-1178, and S. V. Dzyuba and R. A. Bartsch, ChemPhysChem, 2002, 3, 161-166, and G. Law and P. R. Watson, Langmuir, 2001, 17, 6138-6141).

Preferably, the cations have alkyl chains from 1 to 20 carbon atoms, more preferably from 1 to 10 carbon atoms. Cations can also be double charged species such as those described in the literature (M. J. Muldoon and C. M. Gordon, Journal of Polymer Science, Part A Polymer Chemistry, 2004, 42, 3865-3869). Cations can also react with other chemicals species, *i*.*e*. they can react with each other to form polymers as described in literature (M. J. Muldoon and C. M. Gordon, Journal of Polymer Science, Part A Polymer Chemistry, 2004, 42, 3865-3869, and R. Marcilla, J. A. Blazquez, R. Fernandez, H. Grande, J. A. Pomposo and D. Mecerreyes, Macromol. Chem. Phys., 2005, 206, 299-304) in order to modify the prepared MRFs based on ILs. Cations can also be covalently bonded to corresponding anions, resulting in zwitterionic liquids(O. E. Geiculescu, R. V. Rajagopal, J. M. Oh, S. E. Creager and D. D. DesMarteau, Abstracts of Papers, 236th ACS National Meeting, Philadelphia, PA, United States, August 17-21, 2008, 2008, PMSE-432, and N. Byrne, P. C. Howlett, D. R. MacFarlane, M. E. Smith, A. Howes, A. F. Hollenkamp, T. Bastow, P. Hale and M. Forsyth, J. Power Sources, 2008, 184, 288-296, and D. R. MacFarlane, A. F. Hollenkamp, P. C. Howlett, M. Forsyth, C. Tiyapiboonchaiya, J. M. Pringle and N. Byrne, (Monash University, Australia; Commonwealth Scientific and Industrial Research Organisation), WO 2006017898, 2006).

Preferably, at least one cation forming the aforementioned ionic liquid is an ammonium cation with at least one organic group, or a phosphonium cation with at least one organic group, or a sulfonium with at least one organic group, or a quaternary nitrogen atom within an aromatic ring system, for example a pyridinium salt or an imidazolium salt.

The anions present in these liquids can be selected of either anion.

Anions of ionic liquids can be complex inorganic anions that are non- or poorly coordinating with respect to the organic cation and non-interfering with respect to the cationically active species. Many suitable anions are conjugated bases derived from protic acids having a pKₐ of less than 4, for example tetrafluoroborate, the conjugate base of fluoroboric acid, which has a pKₐ < 5).

Other suitable anions are charged adducts of Brønsted-Lowry or Lewis acids, including, but not limited to carboxylates (*e.g*. acetate, acrylate, adipate, bicarbonate, carbamatess, carbonate, chloroacetate citrate, dimethylsulfoniopropionate, formate, hydrogen oxalate, jasmonate, malonate, (meth)acrylates, oxalate, 3-phosphoglycerate, propionate, succinate, tartrate, trifluoroacetate, valerate, *etc*.), acid-fucntionalized polymers (*e.g*. alginates, hyaluronate, etc.), carbanions (*e.g*. acetylides, fulminate), metallates (*e.g*. anionic carboranes, anionic keggin structures, antimonate, antimonite, arsenate, arsenite, chromate, dichromate, ferrate, ferricyanide, ferrocyanide, hexacyano-chromate(II), hexafluoroantimonate, manganate, molybdate, permanganate, perrhenate, pertechnetate, plumbate, plumbite, tellurate, tetrathiomolybdate, trichlorozincate, tungstate, uranates, vanadate, *etc*.), non- or weakly-coordinating anions (*e.g*. bistriflimide, hexafluoro-aluminate, methylrhenium trioxide, nitrate, perchlorate, tetrafluoroborate, tetra-haloaluminates, tetrakis[(3,5-trifluoromethyl)-phenyl]borate ("BARF"), tris(trifluoromethylsulfonyl)methide, *etc*.), sulfonates (*e.g*. ethanesulfonate, fluorosulfonate, methanesulfonate, nonaflate, tosylate, *etc*.), as well as other common anions and categories of anions, such as alkylphosphonates, alkylsulfates, alkyltrihalo-aluminates, aluminate, alkylamides, anionic polyhedral boranes, arsenide, azide, bis(alkylsulfonyl)imides, bis(perfluoroalkylsulfonyl)imides, bismuthide, bisulfite, Borate, bromate, bromide, substituted carbonates, chlorate, chloride, chlorite, cyanate, cyanide, dialkylphosphates, dialkylphosphinates, dichlorocuprate, dicyandiamide, dihydrogen phosphate, dithionate, dluoride, hexafluoroarsenate, hexafluorophosphate, hydride, hydrogen carbonate, hydrogen phosphate, hydrogen sulfate, hydrogen sulfite, hydrosulfide, hydroxide, hypobromite, hypochlorite, hyponitrite , hypophosphite, iodate, iodide, 2-(2-alkoxyethoxy)ethylsulfates, nitride, nitrite, orthonitrate, oxide, periodate, peroxide, peroxynitrate, peroxynitrite, phosphate, phosphide, phosphite, polyfluorinated tetraarylborates, pyrophosphate, Rongalite and other substituted alkylsufonites, selenate, selenide, selenite, silicate, stannate, stannite, sulfate, sulfide, sulfite, superoxide, telluride, tetraalkylborates, tetrachloroborate, tetrahydroxyborate, thiocarbonate, thiocyanate, and thiosulfate. This list is not intended to be exhaustive, but representative of the general categories of corresponding anionic species.

The anion contributes to the overall characteristies of the ionic liquid including physical and chemical properties, such as chemical stability in presence of air and water and solubility with other substances (P. Bonhote, A.-P. Dias, N. Papageorgiou, K. Kalyanasundaram and M. Graetzel, Inorg. Chem., 1996, 35, 1168-1178, and R. Marcilla, J. A. Blazquez, R. Fernandez, H. Grande, J. A. Pomposo and D. Mecerreyes, Macromol. Chem. Phys., 2005, 206, 299-304, and A. Bagno, C. Butts, C. Chiappe, F. D'Amico, J. C. D. Lord, D. Pieraccini and F. Rastrelli, Organic & Biomolecular Chemistry, 2005, 3, 1624-1630). For example, in general, ionic liquids containing chloride anions are hydrophilic, and ionic liquids containing hexafluorophosphate anions are hydrophobic. An advantage of the bistriflimide anion is that these provide ionic liquids with viscosities and densities similar to water, making them easier to process using microfluidic techniques, such as drop-on-demand printing.

A preferred ink contains an imidazolinium salt and/or a phosphonium salt as an ionic liquid, very preferred a 1-alkyl-3-alkylimidazolinium salt and/or a tetraalkylphosphonium salt and/or a tetraalkylammonium salt.

The amount of the ionic liquid or mixture of ionic liquids in the inks of this invention is in the range between 1 and 99 % by weight, preferably between 10 and 30 % by weight, referring to the total composition of the ink.

The polymerisable monomer(s) used in the ink of this invention can be any monomer which is liquid at the selected printing temperature or may be solubilized in a suitable solvent, which allows the formation of polymers, preferably the formation of crosslinked polymers.

The term "polymer" as used in this specification shall mean a polymer forming linear polymer, forming a branched polymer or forming a three-dimensional polymer network. Thus, the term polymer is used in its broadest sense. Polymers can be prepared by any polymerization reaction mechanism resulting in the formation of polymers from the starting monomers. The polymerization can be performed by using monomers with one, two or more polymerizable groups in the molecule. If branched or crosslinked polymers are produced, this can be performed by using monomers with two or more polymerizable groups in a molecule ("crosslinker monomer") optionally in combination with another crosslinker monomer or by using monomers with one polymerizable group in a molecule combined with at least one crosslinker monomer.

Preferably, monomers are selected which allow the formation of crosslinked polymeric networks which are swellable in a selected solvent, usually, but not limited to the ionic liquid used in this application.

As polymerisable monomers, mixtures of monomers can be used, which are liquid at the printing conditions of step i).

In a preferred embodiment, a solution of a polymerisable monomer or of polymerisable monomers are dissolved in an ionic liquid, or in a solvent mixture containing an ionic liquid and additional cosolvent, such as water, alcohols, ketones, polar aprotic solvents (*e.g*. dimethyl sulfoxide, dimethyl formamide), or halogenated alkanes, aliphatic or aromatic ethers or hydrocarbons. This solution can contain additional components, for example polymerization initiators and/or additives to modifiy a selected property. The viscosity and surface tension of the solution are tuned appropriately by adjusting the solvent system and temperature to ensure that the solution is printable.

In another preferred embodiment, oligomers with polymerisable groups or polymers with polymerisable groups can be used as polymerisable monomers, provided that either these oligomers or polymers are liquid at the processing temperature of step, or yield a processable solution when diluted with a suitable solvent system.

In another preferred embodiment, polymerizable monomers or polymerizable monomers in a volatile, non-ionic liquid solution are deposited into the desired pattern onto the substrate surface and then are crosslinked. Then, the polymer pattern is dried to remove the solvent, and the dried polymer pattern is then re-swollen by contacting said polymer pattern with a pattern using ionic liquid. For such a system, the monomer must be soluble in the original solvent used to dispense the monomer, and the polymer must be swellable in the ionic liquid.

If crosslinked polymers which are swellable in a hydrophilic solvent are desired, the monomer or monomer mixtures to be polymerised should themselves be at least in part hydrophilic.

The monomers or monomer mixtures used in the ink of step i) can contain different chemical classes with polymerise with different chemical reactions. For example, monomers containing polymerizable olefinic bonds, urethane- and/or polyamide-forming materials or an appropriate emulsion of polyoxetane or polyepoxide prepolymers may be used.

Preferably, radically polymerisable monomers are used. These monomers in general contain at least one, preferably at least two ethylenically unsaturated groups in the molecule.

All monomers used in the ink of step i) of the process of this invention can be hydrophobic (thus forming either no or very weak hydrogen bonds with water or phase separating from water and from related polar solvents); alternatively all monomers can be hydrophilic (thus being capable of forming thermodynamically favorable transient hydrogen bonds with water or being soluble or swellable in water and other polar solvents) or a combination of hydrophobic and hydrophilic monomers can be used. Furthermore, amphiphilic monomers can be used.

In a preferred variant of the process of this invention, at least one monomer must be ionic liquid-swellable homopolymer when polymerised alone. This monomer can be combined with other copolymerisable monomers, for example with other hydrophilic monomers, or with hydrophobic monomers, which form non-water-swellable homopolymers when polymerised alone.

A preferred monomer is a difunctional α-unsaturated carboxylic acid ester, such as poly(ethylene glycol) dimethacrylate. Monomers with more polymerizable functional groups, such as trifunctional, tetrafunctional, pentafunctional or hexafunctional esters of α-unsaturated carboxylic acids, are also preferred, as well as polyfunctionalized macromonomers, such as methacrylate-functionalized polysaccharides.

Another preferred monomer is a difunctional unsaturated polysiloxane, for example a polysiloxane carrying terminal vinyl, allyl or ethylenically unsaturated carboxylic acid ester groups, such as poly(dimetylsiloxane) with terminal acrylate- or methacrylate groups. In this embodiment also monomers with three or more polymerizable functional groups can be present.

When polymerized alone, these multifunctional monomers form heavily cross-linked polymer networks. With the addition of some monofunctional co-monomers, such ethylenically unsaturated acids, amides thereof, or esters thereof, the crosslinking density can be reduced, the swellability of the network in water increased, and the stiffness of the system becomes modified.

Examples of these monofunctional comonomers are acrylic acid, methacrylic acid, crotonic acid, tiglic acid, vinylsulfonic acid, vinylphosphonic acid or the amides or the esters thereof, preferably the alkylesters thereof. Such co-monomers may also include monofunctionalized oiliomers and prepolymers, such as low molecular weight poly(ethylene glycol) methyl ether methacrylate, (methy)acrylate- modified polyvinyl alcohol, meth(acrylate) modified starches, and the like.

A preferred combination of monomers used in the ink of step i) is a diacrylate of a polyethylene glycol and/or a dimethacrylate of a polyethylene glycol, which is optionally combined with a triacrylate of a trivalent alcohol, a trimethacrylate of a trivalent alcohol, a tetraacrylate of a tetravalent alcohol and/or a tetramethacrylate of a tetravalent alcohol.

Very preferred combinations of monomers in the ink used in step i) are combinations of a diacrylate and/or a dimethacrylate of a polyalkylene oxide with a diacrylate and/or a dimethacrylate of a C₂-C₈ aliphatic alcohol without ether groups in the molecule.

The amount of the monomer or of the mixture of monomers in the inks of this invention is in the range between 10 and 99 % by weight, preferably between 5 and 40 % by weight, referring to the total composition of the ink.

Once the ink is printed as a pattern onto the surface(s) of the substrate, the polymerisable monomer is caused to polymerise and to form a polymer in the presence of the ionic liquid. The polymerisation conditions depend on the nature of the polymerisable monomer, and can be selected by the skilled artisan using routine experiments.

For example, if radically polymerisable monomers containing ethylenically unsaturated groups are present, a radical forming material known as polymerisation initiator may be added or said initiator may be already be present and the conditions, such as the temperature of the ink or the raditation impinging on the surface of the substrate, may be altered in order to start the polymerisation.

Examples of radical initiators include, but are not limited to, organic or inorganic peroxides, organic hydroperoxides or organic or inorganic peracids. Examples of radical initiators are dicumyl peroxide, benzoyl peroxide, 2,4-pentanedione peroxide, 3-chloroperbenzoic acid, benzoyl peroxide, 1,1-bis(tert-amylperoxy)cyclohexane, 1,1-bis(tert-butylperoxy)-3,3,5-trimethylcyclohexane, 1,1-bis(tert-butylperoxy)-cyclohexane, bis(*tert*-butylperoxyisopropyl)-benzene, ,5-Bis(tert-butylperoxy)-2,5-dimethylhexane, 2,5-di(tert-butylperoxy)-2,5-dimethyl-3-hexyne, cumene hydroperoxide, dicumyl peroxide, di-*tert*-amyl peroxide, lauroyl peroxide, peracetic acid, *tert*-amyl peroxybenzoate, *tert*-butyl hydroperoxide, *tert*-butyl peracetate, *tert-*butyl peroxide, *tert*-butyl peroxybenzoate, hydrogen peroxide, ammonium persulfate, hydroxy-methanesulfinic acid monosodium salt dehydrate, potassium persulfate or sodium persulfate. These radical initiators can also be used in combination with a redox system, such as with iron-II-salts or with other redox agents.

Instead of peroxides thermal initiators may be used, such as 1,1'-azobis-(cyclo-hexanecarbonitrile), 2,2'-azobis(2-methylpropionamidine) dihydrochloride, 2,2'-azobis(2-methylpropionitrile), or 4,4'-azobis(4-cyanovaleric acid).

In the alternative, organic photoinitiators, may be used. Examples thereof are 1-hydroxycyclohexyl phenyl ketone, 2,2-diethoxyacetophenone, 2-benzyl-2-(dimethyl-amino)-4'-morpholino-butyrophenone, 2-hydroxy-2-methylpropiophenone, 2-hydroxy-4'-(2-hydroxyethoxy)-2-methylpropiophenone, 2-methyl-4'-(methylthio)-2-morpholino-propiophenone, 3,6-bis(2-methyl-2-morpholinopropionyl)-9-octylcarbazole, 3'-hydroxyacetophenone, 4'-ethoxyacetophenone, 4'-hydroxyacetophenone, 4'-phenoxyacetophenone, 4'-*tert*-butyl-2',6'-dimethylacetophenone, acetophenone, 2,2-dimethoxy-2-phenylaceto-phenone, 4-(dimethylamino)benzoin, 4,4'-cimethylbenzil, benzoin ethyl ether, benzoin isobutyl ether, benzoin methyl ether, benzoin, [2-(acryloyloxy)ethyl]-trimethylammonium chloride, (4-benzoylbenzyl)trimethylammonium chloride, [2-(acryloyloxy)ethyl](4-benzoylbenzyl)dimethylammonium bromide, 2,5-dimethyl-benzophenone, 2-methylbenzophenone, benzophenone-3,3',4,4'-tetracarboxylic dianhydride, 3,4-dimethylbenzophenone, 3-hydroxybenzophenone, 3-methylbenzophenone, 4-(diethylamino)benzophenone, 4-(dimethylamino)benzophenone, 4-(p-tolylthio)benzophenone, 4,4'-bis[2-(1-propenyl)phenoxy]benzophenone, 4,4'-bis(diethylamino)benzophenone, Michler's ketone, 4,4'-dihydroxybenzophenone, 5,5'-methylenebis(2-hydroxy-4-methoxybenzophenone), or benzophenone.

Alternatively, prolymerization initiation may also be achieved using living radical polymerization conditions, combining a free radical initiator such as an azo comnpound with a nitroxide-mediated polymerization initiators such as 2,2,5-trimethyl-3-(1-phenylethoxy)-4-phenyl-3-azahexane, 2,2,6,6-Tetramethyl-1-piperidinyloxy, free radical (TEMPO) and its derivatives, 2-azaadamantane-N-oxyl free radical, and other derivatives of nitroxide free radicals (B. G. G. Lohmeijer and U. S. Schubert, Journal of Polymer Science, Part A Polymer Chemistry, 2004, 42, 4016-4027). Another alternative living free-radical polymerization strategy that may be employed involves the use of reversible addition-fragmentation chain transfer (RAFT) (J. Chiefari, Y. K. Chong, F. Ercole, J. Krstina, J. Jeffery, T. P. T. Le, R. T. A. Mayadunne, G. F. Meijs, C. L. Moad, G. Moad, E. Rizzardo and S. H. Thang, Macromolecules, 1998, 31, 5559-5562) using dithioesters, dithiocarbamates, trithiocarbonates, and xanthates. Another living radical polymerization approach that is applicable is atom transfer radical polymerization, normally facilitated by the use of an alkyl halide initiator, a transition metal catalyst and a polyamine (J.-S. Wang and K. Matyjaszewski, J. Am. Chem. Soc., 1995, 117, 5614-5615).

After the polymerisation is finished, an electrically conductive pattern containing a polymer or a mixture of polymers and an ionic liquid or a mixture of ionic liquids is formed at the surface of the substrate. After the polymerisation of the monomer(s), a continuous, semisolid, conductive ionic liquid swollen gel is obained. The ionic liquid imparts the ability to transfer charge through the material, as well as to swell the matrix and to ensure stable viscoelastic behavior. Since ionic liquids have negligible vapor pressure, and thus cannot dry out (in contrast to hydrogels or other organogels based on volatile solvents). Such materials are typically amorphous monophases, preferably with a transparent appearance. Since they are deposited by a drop-on-demand technique, their structure can be controlled on a multi-micron scale.

Ink-jet printing is a preferred drop-on-demand method in the process of this invention. This technique allows with high precision to rapidly dispense small aliquots of liquid. The advantage to using drop-on-demand inkjet printing over, for example, continuous is that only the desired aliquot of ink is printed, minimizing the material waste and risk of contamination of the formulation sensitive ink. Likewise, by avoiding printing techniques that invariably involve the need for ink recycling steps (H. P. Le, J. Imaging Sci. Technol., 1998, 42, 49-62), one can avoid much unnecessary shear stress exposure to sheer-sensitive components, such as prepolymers. By avoiding inherently unreliable recirculation systems required for the continuous ink-jet technology, the use of drop-on-demand technology is a advantageous feature when working with reactive, crosslinkable inks.

Predetermined surface patterns of the ink can be layers covering the whole surface or other forms of surface coverage. Preferably surface patterns cover portions of the surface, for example in the form of tracks and/or of isolated spots of ink. Several surfaces of the substrate can be coated. For example, two surfaces of a sheet material can be coated in the form of tracks which are optionally connected via holes going through the substrate and containing conductive material.

Initially, the coating material that forms the patterns on said surface(s) is present as a fluid of the ionic liquid(s), optionally the monomer(s) and the additional optional components. This fluid coating material is hereinafter referred to as "ink".

The ink is applied to the surface of the substrate by means of a printing technique and forms a electroconductive pattern after polymerization of the monomer(s).

The application of the ink to the substrate surface can be performed by any drop-on-demand technique. Said drop-on-demand technique implies ejecting a discrete amount of liquid onto a specific location. An important feature of such drop-on-demand technique for the process of this invention is its ability to eject uniform droplets. Examples of drop-on-demand techniques are drop-on-demand inkjet techniques, such as thermal, piezoelectric, electrostatic or acoustic inkjet techniques.These technologies are known to those skilled in the art and are published (for example, see: R. Chang, J. Nam and W. Sun, Tissue Eng., Part A, 2008, 14, 41-48, and S. Cohen, T. Yoshioka, M. Lucarelli, L. H. Hwang and R. Langer, Pharmaceutical Research, 1991, 8, 713-720, and M. C. Lamas, C. Bregni, M. D'Aquino, J. Degrossi and R. Firenstein, Drug Dev. Ind. Pharm., 2001, 27, 825-829). A preferred example of an applicable technique for step i) is ink-jet printing, for example ink-jet printing using piezoelectric technique or using bubble-jet technique.

After the application of the ink to the substrate surface, any vaporizable material in said ink may be removed. For example, by printing the pattern onto a substrate at an elevated temperature, or exposing the polymerized pattern to vacuum, volatile components of the ink may be vaporized. In an alternative or an additional step, the vaporizable material can be evaporated or decomposed after the printing of the ink by using laser radiation impinging on to the imprinted surface immediately after the printing step.

After a predetermined ink pattern has been formed by printing on the substrate surface(s), the imprinted substrate is subjected to conditions that cause the monomer(s) to polymerized. This can be an exposure for a selected time to actinic radiation, for example to laser radiation, or a heat treatment of the imprinted substrate, for example in an oven or by using microwave radiation and/or infrared raditation.

The processed substrates containing conductive surface patterns can be compiled to form a layered product with several substrates possessing conductive patterns in the interior and on the surface. The layered products can contain layers of other materials besides the processed substrates containing conductive surface patterns of metal.

The equipment for performing the method of this invention can be chosen from known equipment. Printing devices, heating devices and irradiation devices are known in the art and commercially available.

The process for generating electrically conductive surface patterns on a substrate surface can be used, for example, for the production of printed wiring boards, of integrated circuits, of decorative sheets, of security labels, of data recording or of data storing media, print boards, of radio frequency identification tags (RFID tags), of organic light emitting devices (OLED), of thin-film transistors (TFT), of selective membranes for electrolysis devices, of printable selective membranes for batteries, of components in thermal batteries, of solid state ultracapacitors, of electrical devices, like heating elements, resistors, coils or antennae, of displays, of smart packages, of flexible circuits, of sensors, preferably of biosensors, or of photovoltaic devices.

These uses are also object of the present invention.

The following Example illustrates the invention without any limitation.

A conductive ink was prepared by combining the ionic liquid tetrapentylammonium thiocyanate, low molecular weight polyethylene glycol dimethycrylate (Mₙ = 440) as polymerisable monomer, a polymerization initiator (Irgacure^{®} 369) and dimethylsulfoxide as a co-solvent. This composition was printed using a standard damped micropipette onto a clean glass silide in a macro-controlled pattern. The pattern was then cured by exposure to UV light, yielding a thin film of ionic liquid on the surface. When the organogel was loaded with 10-50 % by weight of ionic liquid, conductivities comparable to that of the pure ionic liquid were achieved (294 mS • cm⁻¹).

## Claims

1. A process for generating electrically conducting surface patterns on a substrate surface comprising the steps:
i) drop-on-demand printing upon the surface of a substrate a predetermined pattern of a material containing a polymerizable monomer and an ionic liquid and/or an ionic liquid with at least one polymerizable group in the molecule, or alternatively, drop-on-demand printing upon the surface of a substrate a predetermined pattern of a material containg a polymerizable monomer, followed by drop-on-demand printing of a predetermined pattern of a fluid containing an ionic liquid, or alternatively, drop-on-demand printing of a predetermined pattern of a material containing an ionic liquid, followed by deposition of a predetermined pattern of a material containing a polymerizable monomer, by printing said compositions onto a surface, and,
ii) after deposition of the monomer causing said polymerizable monomer and/or said polymerizable group to polymerize, forming a polymer thereby forming a polymerized, electrically conductive pattern on said surface.

2. The process as claimed in claim 1, wherein the substrate is selected from the group consisting of a polymer, of an inorganic material, preferably glass or a ceramic material, of semi-conducting substrates, preferably silicon or gallium-arsenide, of fibrous substrates containing natural and/or man-made fibers, preferably paper, textile sheets including fabrics and non-wovens, of sheet materials made from polymers and/or from natural materials, preferably leather, wood or thermoplastic polymers, of bulk materials made from polymers and/or from natural materials, of composites containing said sheet or bulk materials or of a combination of two or more of these materials.

3. The process as claimed in claim 2, wherein the polymer has a glass transition-or melting temperature below 180°C, and is preferably selected from the group consisting of a polyester, a polyamide, a polyolefin or a combination of two or more thereof.

4. The process as claimed in claim 1, wherein the ionic liquid comprises a cation selected from the group of ammonium with at least one organic group, or of phosphonium with at least one organic group, or of sulfonium with at least one organic group, or of quaternary nitrogen atom containing heterocyclic group.

5. The process as claimed in claim 4, wherein the ionic liquid is selected from the group of imidazolinium salt, of phosphonium salt, of ammonium salt or of a combination of two or more thereof.

6. The process as claimed in claim 1, wherein in step i) a solution of a polymerisable monomer or of polymerisable monomer mixtures in an inert solvent or in inert solvent mixtures are used.

7. The process as claimed in claim 1, wherein the polymerisable monomer comprises a difunctional α-unsaturated carboxylic acid ester, preferably a poly(ethylene glycol) di(meth)acrylate.

8. The process as claimed in claim 1, wherein the polymerisable monomer comprises a difunctional α-unsaturated carboxylic acid ester, preferably a poly(dimethyl siloxane) di(meth)acrylate.

9. The process as claimed in claim 7, wherein the polymerisable monomer comprises a poly(ethylene glycol) di(meth)acrylate in combination with a triacrylate of a trivalent alcohol, a trimethacrylate of a trivalent alcohol, a tetraacrylate of a tetravalent alcohol and/or a tetramethacrylate of a tetravalent alcohol.

10. The process as claimed in claim 1, wherein the printing of the ink is performed by a drop-on-demand direct write technique, preferably by a drop-on-demand inkjet technique.

11. Use of the process according to any of the claims 1 to 10 for the production of printed wiring boards, of integrated circuits, of decorative sheets, of security labels, of data recording or of data storing media, of print boards, of radio frequency identification tags, of organic light emitting devices, of thin-film transistors, of selective membranes for electrolysis devices, of printable selective membranes for batteries, of components in thermal batteries, of solid state ultracapacitors, of electrical devices, of displays, of smart packages, of flexible circuits, of sensors or of photovoltaic devices.
